Europäisches Patentamt

European Patent Office

Office européen des brevets

(19)

(11) Veröffentlichungsnummer : **0 033 455**
**B1**

(12) **EUROPÄISCHE PATENTSCHRIFT**

(45) Veröffentlichungstag der Patentschrift :
**18.01.84**

(51) Int. Cl.³ : **H 03 H 19/00**

(21) Anmeldenummer : **81100313.6**

(22) Anmeldetag : **16.01.81**

(54) **Elektrische Filterschaltung unter Verwendung von wenigstens einer simulierten Induktivität, die gesteuerte Schalter, Kondensatoren und Verstärker enthält.**

(30) Priorität : **21.01.80 DE 3001969**

(43) Veröffentlichungstag der Anmeldung :
**12.08.81 Patentblatt 81/32**

(45) Bekanntmachung des Hinweises auf die Patenterteilung : **18.01.84 Patentblatt 84/03**

(84) Benannte Vertragsstaaten :
**AT BE CH FR GB IT LI NL SE**

(56) Entgegenhaltungen :
**EP-A- 0 024 011**
**ELECTRONICS LETTERS, Band 15, Nr. 16, 2. August 1979, Seiten 494-496 London, G.B. U.W. BRUGGER et al.: "Switched-capacitor simulation of floating inductors using gyrators"**
**ELECTRONICS LETTERS, Band 14, Nr. 24, 23. November 1978, Seiten 788-790 London, G.B. B.J. HOSTICKA et al.: "Switched-capacitor simulation of grounded inductors and gyrators"**
**ELECTRONICS LETTERS, Band 16, Nr. 4, 14. Februar 1980, Seiten 141-142 Hitchin, G.B. J.A. NOSSEK: "Improved circuit for switched-capacitor simulation of an inductor"**
**IEEE TRANSACTIONS ON CIRCUITS AND SYSTEMS, Band CAS-27, Nr. 6, Juni 1980, Seiten 481-491 New York, U.S.A. J.A. NOSSEK et al.: "Switched-capacitor filter design using bilinear element modeling"**
**ELECTRONICS LETTERS, Band 15, Nr. 3, 1. Februar 1979, Seiten 87-88 London, G.B. G.C. TEMES et al.: "Switched-capacitor circuits bilinearly equivalent to floating inductor or F.D.N.R."**

(73) Patentinhaber : **SIEMENS AKTIENGESELLSCHAFT Berlin und München Wittelsbacherplatz 2 D-8000 München 2 (DE)**

(72) Erfinder : **Nossek, Josef, Dipl.-Ing. Noestrasse 30 D-8000 München 71 (DE)**

## Elektrische Filterschaltung unter Verwendung von wenigstens einer simulierten Induktivität, die gesteuerte Schalter, Kondensatoren und Verstärker enthält

Die Erfindung betrifft eine elektrische Filterschaltung unter Verwendung von wenigstens einer simulierten Induktivität, die nach vorgegebenen Taktphasen gesteuerte Schalter, Kondensatoren und Verstärker enthält und bei der ein Operationsverstärker vorgesehen ist, zwischen dessen Ausgang und invertierendem Eingang ein Kondensator geschaltet ist und dessen nicht invertierender Eingang an ein festes Bezugspotential, insbesondere Massepotential geschaltet ist, bei der vom invertierenden Eingang des Operationsverstärkers ein Schalter zu einem ersten Schaltungsknoten führt, von dem aus ein Kondensator nach Massepotential geschaltet ist, und dieser Schaltungsknoten über einen Schalter mit der ersten Eingangsklemme verbunden ist.

Schalterfilter dieser Art sind aus der Zeitschrift « Electronic Letters », Bd. 15, Nr. 16, 2. August 1979, Seiten 494 bis 496 bekannt. Es werden dabei Gyratoren zur Spulennachbildung verwendet.

Schalterfilter sind für sich auch durch den Aufsatz « Switched-Capacitor Filter Design Using the Bilinear z-Transform » in der Zeitschrift « IEEE Transactions on Circuits and Systems », Vol. Cas-25, Nr. 12, Dez. 1978, Seiten 1039 bis 1044 und auch durch die Arbeit « Switched-Capacitor Circuits Bilinearly Equivalent to Floating Inductor or F.D.N.R. » in der Zeitschrift « Electronics Letters », 1 Feb. 1979, Vol. 15, Nr. 3, Seiten 87 und 88, bekannt geworden. Es handelt sich dabei um solche Filter, die nicht zeitkontinuierliche Analogsignale im eigentlichen Sinne verarbeiten, sondern zeitdiskrete Signale, die in Form von Abtastproben vorliegen, wobei die Abtastproben im Rhythmus einer Taktfrequenz F erzeugt werden und über die Beziehung $T = 1/F$ wird dementsprechend T die Taktperiode genannt. Schaltungen zur Erzeugung solcher Abtastproben sind für sich bekannt, so daß sie an dieser Stelle nicht im einzelnen erläutert werden müssen. Es ist jedoch auch im folgenden davon auszugehen, daß den dargestellten Schaltungen solche Abtastschaltungen jeweils vor- bzw. nachgeschaltet sein können, so daß es also einerseits gelingt, aus einem Analogsignal entnommene Abtastproben der Filterschaltung eingangsseitig zuzuführen und die ausgangsseitig zur Verfügung stehenden Signale wieder in zeitkontinuierliche Analogsignale umzuwandeln. Der wesentliche technische Vorteil solcher Filter ist darin zu sehen, daß Spulen durch aktive Schaltelemente und Kondensatoren nachgebildet werden, so daß sie sich zur monolithischen Integration von größeren Filterschaltungen eignen. Als Verstärker werden dabei überwiegend die bekannten Operationsverstärker eingesetzt und es wird dabei angestrebt, einerseits einer möglichst geringe Anzahl von Schaltelementen anwenden zu müssen und andererseits auch die Stabilität solcher Schaltungen zu gewährleisten. Bei den vorerwähnten bekannten Schaltungen wird ebenfalls der invertierende Eingang mit dem Ausgang eines Operationsverstärkers über einen Kondensator verbunden, also gewissermaßen gegengekoppelt. Jedoch zeigt sich, daß die zum Einsatz kommenden Operationsverstärker zeitweilig nicht gegengekoppelt sind bzw. eine hohe Gleichtaktunterdrückung benötigen, da der nicht invertierende Eingang des Operationsverstärkers während gewisser Schaltphasen kurzzeitig nicht gegengekoppelt ist bzw. nicht stets auf Massepotential gehalten wird. Weiterhin erfolgt die Realisierung der Kondensatoren in der Art der MOS-Technologie (Metalloxydsilizium-Technologie) und es zeigt sich, daß bei diesen Realisierungsverfahren die unvermeidlichen mit jedem schwebenden MOS-Kondensator verbundenen Erdkapazitäten zu erheblichen Störungen der Filterfunktion führen können.

Der Erfindung liegt die Aufgabe zugrunde, Schaltungen zur Nachbildung von aktiv realisierbaren Spulen und Parallelresonanzkreisen anzugeben, die sowohl als schwebende als auch als einseitig geerdete Spulen in sogenannten Switched-Capacitor-Filtern eingesetzt werden können und bei denen die durch Schaltvorgänge auftretenden Störungen nach Möglichkeit vermieden sind.

Ausgehend von den einleitend genannten Filterschaltungen wird diese Aufgabe erfindungsgemäß dadurch gelöst, daß vom invertierenden Eingang des Operationsverstärkers ein Schalter zu einem ersten Schaltungsknoten führt, von dem aus ein Kondensator nach Massepotential geschaltet ist, und ein Schalter zu einem zweiten Schaltungsknoten führt, von dem aus ein Kondensator nach Massepotential geschaltet ist, daß vom zweiten Schaltungsknoten ein Schalter zum Ausgang des Operationsverstärkers führt, von dem aus ein Schalter zum ersten Schaltungsknoten führt, daß dieser Schaltungsknoten über einen Schalter mit der ersten Eingangsklemme verbunden ist, und daß die Schalter während einer Taktphase schließen und anschließenden, zeitlich nicht überlappenden Taktphasen entsprechend die Schalter geschlossen sind.

Weitere vorteilhafte Ausgestaltungen sind in den Unteransprüchen angegeben.

Anhand von Ausführungsbeispielen wird nachstehend die Erfindung noch näher erläutert.

Es zeigen in der Zeichnung

Figur 1 die Realisierung einer einseitig geerdeten Induktivität ;

Figur 2 das Taktschema, in dem die einzelnen Schalter in den Taktphasen 1 bis 4 betätigt werden ; die Taktperiode ist mit T bezeichnet ; das Taktschema hat auch für die Schaltungen nach den Fig. 5 und 6 Gültigkeit ;

Figur 3 das elektrische Ersatzschaltbild für die Schaltung nach Fig. 1 ; mit L als Induktivitätswert der Spule und s als komplexe Frequenz ;

Figur 4 das elektrische Ersatzschaltbild für einen schwebenden Parallelresonanzkreis mit der Kapazität C und der Induktivität L ;

Figur 5 eine Schaltung zur Realisierung einer schwebenden Induktivität bzw. eines Parallelresonanzkreis, dessen Resonanzfrequenz kleiner als F/6 ist ;

Figur 6 eine Schaltung zur Realisierung eines schwebenden Parallelresonanzkreis, dessen Resonanzfrequenz größer als F/6 ist.

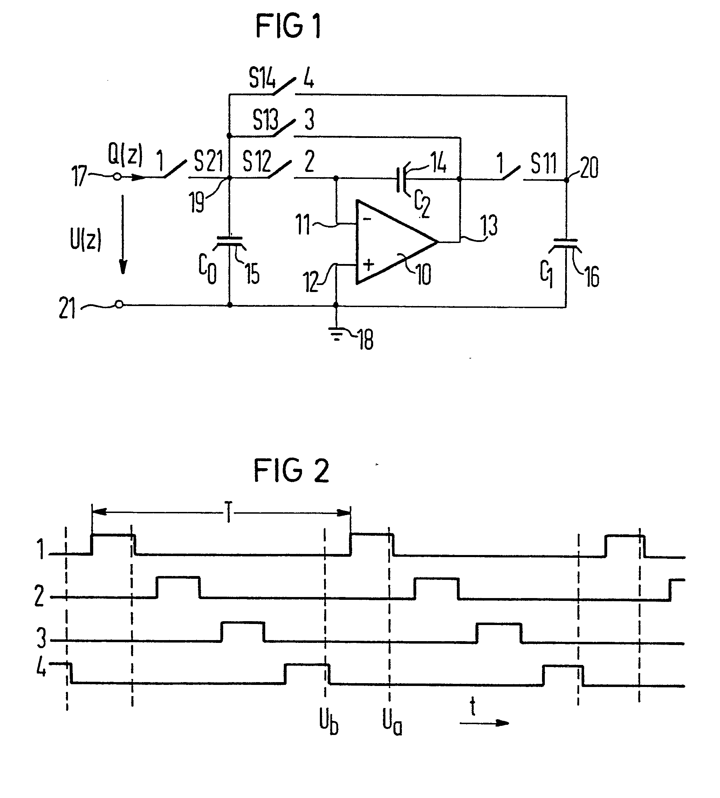

Fig. 1 zeigt ein Ausführungsbeispiel, bei dem ein elektrischer Zweipol realisiert ist, dessen erste Eingangsklemme mit der Bezugsziffer 17 und dessen zweite Eingangsklemme mit der Bezugsziffer 21 bezeichnet ist. Zwischen den beiden Anschlüssen 17 und 21 liegt die Eingangsspannung U(z) und in die Schaltung fließt die Ladung Q(z). Die Anschlußklemme 21 liegt zugleich auf Massepotential 18. Als aktives Element ist der mit 10 bezeichnete Operationsverstärker vorgesehen mit dem invertierenden Eingang 11, dem nicht invertierenden Eingang 12 und dem Ausgang 13. Zur besseren Übersicht sind ein- und ausgangsseitig zwei Schaltungsknoten 19 und 20 eingezeichnet, von denen der Schaltungsknoten 19 über den Kondensator 15 und der Schaltungsknoten 20 über den Kondensator 16 auf Massepotential 18 geführt sind. Der Ausgang 13 des Operationsverstärker 10 ist über einen Kondensator 14 mit dem invertierenden Eingang 11 verbunden, der nicht invertierende Eingang 12 liegt auf Massepotential 18. Die Kapazitätswerte der Kondensatoren 14 bzw. 15 bzw. 16 sind mit $C_2$ bzw. $C_0$ bzw. $C_1$ ebenfalls eingetragen.

Im Gesamtnetzwerk sind ferner eine Reihe von Schaltern erforderlich, so daß also die Eingangsklemme 17 und der Schaltungsknoten 19 über den Schalter S21 verbunden sind ; dem Schaltungsknoten 19 folgen die Schalter S12, S13 und S14, der Schalter S11 verbindet den Ausgang 13 des Operationsverstärkers mit dem Kondensator 16.

Für die Betriebsweise der einzelnen Schalter ist das in Fig. 2 in Abhängigkeit von der Zeit t dargestellte Taktschema maßgebend, in dem die einzelnen Taktphasen mit 1, 2, 3 und 4 bezeichnet sind. Dieses Taktschema gilt auch für die folgenden Figuren und es ist die Bezeichnung so gewählt, daß an den einzelnen Schaltern die zweite Ziffer jeweils übereinstimmt mit der Taktphase, in der der jeweilige Schalter geschlossen ist und die erste Ziffer eine Zählvariable darstellt. Wie Fig. 2 weiter erkennen läßt, ist davon auszugehen, daß sich die Schließungsdauern der Schalter nicht überlappen. Mit $U_a$ ist der Zustand nach dem Schalten (« after ») und mit $U_b$ der Zustand vor dem Schalten (« before ») bezeichnet. In Anwendung der vorstehenden Ausführungen schließen also im Ausführungsbeispiel von Fig. 1 die Schalter S11 und S21 während der Taktphase 1, der Schalter S12 während der Taktphase 2, der Schalter S13 während der Taktphase 3 und schließlich der Schalter S14 während der Taktphase 4.

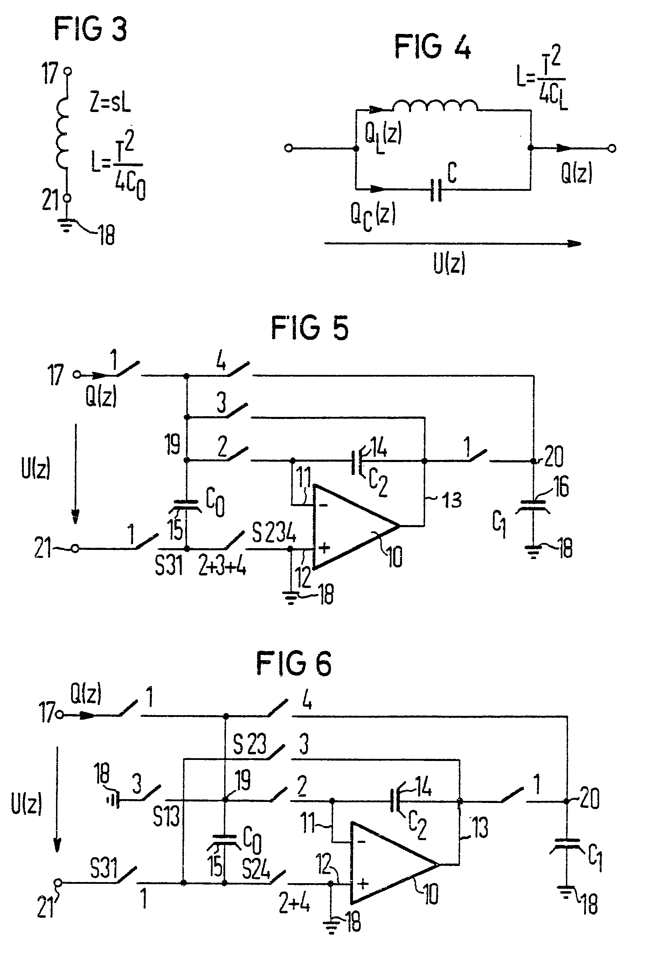

Wie bereits erwähnt, gilt dies analog auch für die Ausführungsbeispiele der Figuren 5 und 6, in denen zur besseren Übersicht im wesentlichen nur noch die Schließungsphasen an den Schaltern angegeben sind und abweichende Schalterbezeichnungen lediglich dort eingeführt sind, wo entsprechende Schaltungsänderungen vorgenommen wurden.

Die in Fig. 1 gezeigte Schaltung hat u. a. den Vorteil, daß bei einer möglichst geringen Anzahl von Bauelementen sich eine einseitig geerdete Induktivität simulieren läßt, die auch als Ausgangsschaltung für die Nachbildung einer schwebenden Induktivität bzw. von Parallelresonanzkreisen dienen kann, ohne daß die Zahl der erforderlichen einzelnen Taktphasen erhöht werden muß.

Hinsichtlich der Bemessung erweist es sich als vorteilhaft, wenn für die Kapazitätswerte der Kondensatoren 14 bzw. 16 die Beziehung gilt $C_2 = C_0/4$ bzw. $C_1 = C_0/3$, wenn $C_0$ die Kapazität des Kondensators 15 ist.

Betrachtet man das elektrische Ersatzschaltbild gemäß Fig. 3, dann ist zwischen der ersten Eingangsklemme 17 und der auf Massepotential 18 liegenden zweiten Eingangsklemme 21 die Impedanz $Z = s \cdot L$ wirksam. Über die in Fig. 3 weiterhin angegebene Beziehung $L = T^2/4C_0$ ist unmittelbar die Kapazität $C_0$ des Kondensators 15 aus dem zu simulierenden Induktivitätswert L über die systemeigene Abtastperiode T zu ermitteln.

Im Ersatzschaltbild von Fig. 4 wird die in Fig. 3 gezeigte Induktivität zu einem schwebenden Parallelresonanzkreis durch Zuschalten des ersatzschaltbildmäßigen Kondensators C ergänzt. In der Induktivität L fließt die Ladung $Q_L(z)$, im Kondensator die Ladung $Q_C(z)$, die Gesamtladung ist mit Q(z) bezeichnet und es tritt der Spannungsabfall U(z) auf. Dieser Parallelresonanzkreis läßt sich unmittelbar mit der Schaltung von Fig. 1 realisieren, das heißt also, es wird an der Eingangsklemme 17 die Ladung Q(z) aufgenommen und es fällt zwischen den Klemmen 17 und 21 die Spannung U(z) ab, wenn die Kondensatoren 14, 15 und 16 nach folgenden Vorschriften bemessen sind :

$$C_0 = C + C_L, \quad C_1 = C_0^2/3C_L - C,$$

$$C_2 = C_0^2/4C_L, \quad C_L = T^2/4L \cdot$$

Die Schaltung nach Fig. 5 eignet sich je nach Bemessung also schwebende Induktivität, die ersatzschaltbildmäßig auf Fig. 3 zurückgeführt werden kann — jedoch ohne das dort eingezeichnete Massesymbol — oder als Parallelresonanzkreis gemäß Fig. 4, dessen Resonanzfrequenz kleiner als F/6 ist. Hinsichtlich der Wirkungsweise und des schaltungstechnischen Aufbaues gelten die vorstehend gegebenen Ausführungen analog. Abweichend von der Schaltung nach Fig. 1 ist in der Schaltung nach Fig. 5 lediglich folgendes. Die zweite Eingangsklemme 21 liegt nun nicht mehr unmittelbar auf Bezugspotential 18, sondern es ist zunächst der Schalter S31 vorgesehen, der während der Taktphase 1 schließt. Ein weiterer Schalter S234 ist dem auf Massepotential 18 liegenden nicht invertierenden Eingang 12 vorgeschaltet und es schließt dieser Schalter während der Taktphasen 2 und 3 und 4. Wie bereits erwähnt, läßt sich das Verhalten eines Parallelresonanzkreises dann erreichen, wenn nach den unmittelbar vorstehenden Beziehungen bemessen wird.

Mit Hilfe der in Fig. 6 gezeichneten Schaltung läßt sich ein Umpolen des Kondensators 15 erreichen und bei Bemessung nach den vorstehenden Formeln kann ein schwebender Parallelresonanzkreis gemäß Fig. 4 für Resonanzfrequenzen, die größer als F/6 sind, realisiert werden. Ein Vergleich der Figuren 1 und 6 läßt unmittelbar erkennen, daß in der Schaltung von Fig. 6 der Ausgang 13 des Operationsverstärkers 10 nicht mehr über den Schalter S13 mit dem Schaltungsknoten 19 verbunden ist, sondern über den mit S23 bezeichneten Schalter auf einen dem Schalter S31 nachfolgenden Schaltungspunkt führt. Ein Vergleich mit Fig. 5 läßt erkennen, daß in Fig. 6 weiterhin der dem nicht invertierenden Eingang 12 des Operationsverstärkers 10 vorgeschaltete Schalter S24 nur mehr während der Taktphasen 2 und 4 schließt. Für den Umpolvorgang des Kondensators 15 ist weiterhin der Schalter S13 erforderlich, der den Schaltungsknoten 19 während der Taktphase 3 mit Massepotential 18 verbindet.

Wie einleitend bereits erwähnt, haben die vorstehend beschriebenen Schaltungen dern Vorteil, daß bei einer möglichst geringen Anzahl von Schaltelementen auch die Zahl der Schalter und damit die Zahl der erforderlichen Taktspannungen möglichst gering gehalten werden kann, so daß sie für einen integrierten Aufbau geeignet sind. Da der Kondensator 14 in allen Schaltungen unmittelbar zwischen dem Ausgang 13 und dem invertierenden Eingang 11 des Operationsverstärkers 10 liegt, ist dieser auch während der Schaltvorgänge der einzelnen Schalter stets gegengekoppelt. Darüber hinaus lassen sich auch Parallelresonanzkreise simulieren, ohne daß hierfür ein nennenswerter schaltungstechnischer Aufwand erforderlich ist.

**Ansprüche**

1. Elektrische Filterschaltung unter Verwendung von wenigstens einer simulierten Induktivität, die nach vorgegebenen Taktphasen (1, 2, 3, 4) gesteuerte Schalter, Kondensatoren und Verstärker enthält und bei der ein Operationsverstärker (10) vorgesehen ist, zwischen dessen Ausgang (13) und invertierendem Eingang (11) ein Kondensator (14) geschaltet ist und dessen nicht invertierender Eingang (12) an ein festes Bezugspotential, insbesondere Massepotential geschaltet ist, bei der vom invertierenden Eingang (11) des Operationsverstärkers (10) ein Schalter (S12) zu einem ersten Schaltungsknoten (19) führt, von dem aus ein Kondensator (15) nach Massepotential (18) geschaltet ist, und dieser Schaltungsknoten (19) über einen Schalter (S21) mit der ersten Eingangsklemme (17) verbunden ist, dadurch gekennzeichnet, daß vom ersten Schaltungsknoten (19) ein Schalter (S14) zu einem zweiten Schaltungsknoten (20) führt, von dem aus ein Kondensator (16) nach Massepotential (18) geschaltet ist, daß vom zweiten Schaltungsknoten (20) ein Schalter (S11) zum Ausgang (13) des Operationsverstärkers (10) führt, und daß die Schalter S11 und S21 während einer ersten Taktphase (1) schließen und in anschließenden, zeitlich nicht überlappenden, zweiten, bzw. dritten, bzw. vierten Taktphasen (2 bzw. 3 bzw. 4) entsprechend die Schalter S12 bzw. S13 bzw. S14 geschlossen sind (Fig. 1, 2, 3).

2. Elektrische Filterschaltung nach Anspruch 1, dadurch gekennzeichnet, daß der Kapazitätswert ($C_2$) des zwischen Ausgang (13) und invertierendem Eingang (11) des Operationsverstärkers (10) liegenden Kondensators (14) den vierten Teil ($C_0/4$) des Kapazitätswerts ($C_0$) des zwischen dem ersten Schaltungsknoten (19) und Massepotential (18) liegenden Kondensators (15) und demgegenüber der zwischen dem zweiten Schaltungsknoten (20) und Massepotential (18) liegende Kondensator (16) den dritten Teil ($C_0/3$) von dessen Kapazitätswert ($C_0$) hat. (Fig. 1, 2, 3).

3. Elektrische Filterschaltung nach Anspruch 1, dadurch gekennzeichnet, daß zur Realisierung eines Parallelschwingkreises mit der ersatzschaltbildmäßigen Induktivität L bzw. Kapazität C die folgende Beziehung gilt :

$$C_0 = C + C_L, \quad C_1 = C_0^2/3C_L - C,$$

$$C_2 = C_0^2/4C_L, \quad C_L = T^2/4L,$$

wobei T die Abtastperiode ist und C bzw. L den Kapazitäts- bzw. Induktivitätswert des zu realisierenden Parallelresonanzkreises bedeuten. (Fig. 1, 2, 4).

4. Elektrische Filterschaltung nach einem der vorhergehenden Ansprüche, dadurch gekennzeichnet, daß der vom ersten Schaltungsknoten (19) ausgehende Kondensator (15) einerseits über einen Schalter (S31) mit der zweiten Eingangsklemme (21) und andererseits über einen Schalter (S234) mit Massepotential (18) verbunden ist, und daß diese beiden Schalter (S31, S234) entsprechend während der ersten Taktphase 1 bzw. während der weiteren Taktphasen 2, 3 und 4 nacheinander geschlossen sind. (Fig. 2, 3, 4, 5).

5. Elektrische Filterschaltung nach Anspruch 4, dadurch gekennzeichnet, daß der erste Schaltungsknoten (19) während der dritten Taktphase (3) anstelle mit dem Ausgang (13) des Operationsverstärkers (10) mit Massepotential (18) über den zugehörigen Schalter (S13) verbunden ist, und daß der vom Schaltungsknoten (19) ausgehende Kondensator (15) mit seinem zweiten Anschluß einerseits über einen während der dritten Taktphase (3) schließenden weiteren Schalter (S23) mit dem Ausgang (13) des Operationsverstärkers (10) und andererseits über einen während der Taktphasen 2 und 4 schließenden Schalter (S24) mit Massepotential (18) verbunden ist (Fig. 6).

## Claims

1. An electrical filter circuit employing at least one simulated inductance, which includes switches, capacitors and amplifiers controlled by predetermined clock pulse phases (1, 2, 3, 4), an operational amplifier (10), having a capacitor (14) inserted between its output (13) and inverting input (11) and its non-inverting input (12) connected to a fixed reference potential, in particular earth potential, the inverting input (11) of the operational amplifier (10) being connected by a switch (S12) to a first circuit node (19) and on to the first input terminal (17) by a switch (S21), characterised in that from the first circuit node (19) a switch (S14) leads to a second circuit node (20), from which a capacitor (16) is connected to earth potential (18), that a switch (S11) leads from the second circuit node (20) to the output (13) of the operational amplifier (10), and that switches S11 and S21 close during a first clock pulse phase (1), and switches S12, S13 and S14 are subsequently closed during respective second, third and fourth clock pulse phases (2 and 3 and 4) which do not overlap in terms of time. (Fig. 1, 2, 3).

2. An electrical filter circuit as claimed in Claim 1, characterised in that the capacitance $(C_2)$ of the capacitor (14) arranged between the output (13) and the inverting input (11) of the operational amplifier (10), is a fourth $(C_0/4)$ of the capacitance $(C_0)$ of the capacitor (15) arranged between the first circuit node (19) and earth potential (18), and compared therewith the capacitor (16) arranged between the second circuit node (20) and earth potential (18) is a third $(C_0/3)$ of the capacitance $(C_0)$ thereof. (Fig. 1, 2, 3).

3. An electrical filter circuit as claimed in Claim 1, characterised in that in order to construct a parallel oscillatory circuit with inductance L or capacitance C, as the case may be, in accordance with the equivalent circuit diagram the following equation is valid :

$$C_0 = C + C_L, \quad C_1 = C_0^2/3C_L - C,$$

$$C_2 = C_0^2/4C_L, \quad C_L = T^2/4L,$$

where T is the sampling period, and C or L, as the case may be, signifies the capacitance or inductance value, as the case may be, of the parallel resonant circuit to be constructed. (Fig. 1, 2, 4).

4. An electrical filter circuit as claimed in one of the preceding Claims, characterised in that the capacitor (15) from the first circuit node (19) is connected to the second input terminal (21) by a switch (S31) and to earth potential (18) by a switch (S234) on the other hand, and these two switches (S31, S234) are correspondingly closed one after another during the first clock pulse phase 1 or during the further clock pulse phases 2, 3 and 4, as the case may be. (Fig. 2, 3, 4, 5).

5. An electrical filter circuit as claimed in Claim 4, characterised in that during the third clock pulse phase (3) the first circuit node (19) is connected to earth potential (18) in place of the output (13) of the operational amplifier (10) via the assigned switch (S13), and that the capacitor (15) from the circuit node (19) is connected to the output (13) of the operational amplifier (10) by a further switch (10), which closes during the third clock pulse phase (3), on the one hand, and connected to earth potential (18) by a switch (S24) which closes during the clock pulse phases 2 and 4. (Fig. 6).

## Revendications

1. Circuit de filtre électrique utilisant au moins une inductance simulée qui contient des commutateurs commandés selon des phases de cadence prédéterminées (1, 2, 3, 4), des condensateurs et des amplificateurs, et dans lequel il est prévu un amplificateur opérationnel (10), entre la sortie (13) et l'entrée inverseuse (11) duquel est branché un condensateur (14) et dont l'entrée non inverseuse (12) est placée à un potentiel de référence fixe, notamment le potentiel de la masse, et dans lequel un commutateur (S12) relie l'entrée inverseuse (11) de l'amplificateur opérationnel (10) à un premier nœud de circuit (19), à partir duquel un condensateur (15) est placé au potentiel de la masse (18), et dans lequel le nœud de circuit (19) est relié par l'intermédiaire d'un commutateur (21) à la première borne d'entrée (17), caractérisé par le fait que le commutateur (S14) relie le premier nœud de circuit (19) à un second nœud de circuit (20), à partir duquel un condensateur (16) est placé au potentiel de la masse (18), qu'un commutateur (S11) relie le second nœud de circuit (20) à la sortie (13) de l'amplificateur opérationnel (10), que les commutateurs (S11) et (S21) se ferment pendant une première phase de cadence (1) et que les commutateurs (S12 ou S13 ou S14) sont fermés de façon correspondante pendant des seconde, troisième ou quatrième phases de cadence (2 ou 3 ou 4) successives ne se chevauchant pas dans le temps (figures 1, 2, 3).

2. Circuit de filtre électrique suivant la revendication 1, caractérisé par le fait que la valeur de la capacité $(C_2)$ du condensateur (14) monté entre la sortie (13) et l'entrée inverseuse (13) de l'amplificateur opérationnel (10) est égale au quart $(C_0/4)$ de la valeur de la capacité $(C_0)$ du condensateur (15) monté entre le premier nœud de circuit (19) et le potentiel de la masse (18), et qu'au contraire, le condensateur (16) situé entre le second nœud de circuit (20) et le potentiel de la masse (18) possède une valeur de capacité égale au tiers $(C_0/3)$ de la valeur de la capacité $(C_0)$

(figures 1, 2, 3).

3. Circuit de filtre électrique suivant la revendication 1, caractérisé par le fait que pour réaliser un circuit oscillant parallèle, avec l'inductance L, et la capacité C conformes au schéma équivalent, on a la relation suivante :

$$C_0 = C + C_L, \quad C_1 = C_0^2/3C_L - C,$$

$$C_2 = C_0^2/4C_L, \quad C_L = T^2/4L,$$

T étant la période d'exploration et C et L les valeurs de la capacité et de l'inductance du circuit résonnant parallèle devant être réalisé (figures 1, 2, 4).

4. Circuit de filtre électrique suivant l'une des revendications précédentes, caractérisé par le fait que le condensateur (15) relié au premier nœud de circuit (19) est relié d'une part par l'intermédiaire d'un commutateur (S31) à la seconde borne d'entrée (21) et d'autre part par l'intermédiaire d'un commutateur (S234) au potentiel de la masse (18), et que ces deux commutateurs (S31, S234) sont fermés successivement de façon correspondante, pendant la première phase de cadence 1 ou pendant les autres phases de cadence 2, 3 et 4 (figures 2, 3, 4, 5).

5. Circuit de filtre électrique suivant la revendication 4, caractérisé par le fait que le premier nœud de circuit (19) est relié, pendant la troisième phase de cadence (3) non pas à la sortie (13) de l'amplificateur opérationnel (18), mais au potentiel de la masse (18) par l'intermédiaire du commutateur (S13) et que le condensateur (15) relié au nœud de circuit (15) est relié par sa seconde borne d'une part par l'intermédiaire d'un commutateur (S23), se fermant pendant la troisième phase de cadence (3), à la sortie (13) de l'amplificateur opérationnel (10) et d'autre part par l'intermédiaire d'un commutateur (S24), se fermant pendant les phases de commutation 2 et 4, au potentiel de masse (18) (figure 6).

# FIG 1

# FIG 2

FIG 3

FIG 4

FIG 5

FIG 6